# FASCICULE DE BREVET EUROPEEN

(11) **EP 2 759 742 B1**
(45) Date de publication et mention de la délivrance du brevet: **09.12.2015**
(21) Numéro de dépôt: 14152196.3
(22) Date de dépôt: 22.01.2014
(51) Int. Cl.: F16H 37/02, F16H 7/14, G01R 31/28, G03F 7/20, F16H 57/021, F16H 57/022

(54) **Dispositif d'entraînement en rotation d'une roue dentée et plateau rotativ motorisé**
Drehantriebsvorrichtung eines Zahnrads und motorgetriebener Drehteller
Device for rotating a toothed wheel and motorized turntable

(30) Priorité: 24.01.2013 FR 1350622
(43) Date de publication de la demande: 30.07.2014
(73) Titulaire: Micro-Controle - Spectra Physics, 91006 Evry Cedex (FR)
(72) Inventeur: Durand, Eric, 45200 AMILLY (FR); Rety, Bruno, 45460 BOUZY LA FORET (FR)
(74) Mandataire: Gevers France

(56) Documents cités:
- DE-A1- 3 804 861
- GB-A- 235 184
- JP-A- 2011 210 956
- US-A- 5 475 930

## Description

La présente invention concerne un dispositif d'entraînement en rotation d'une roue dentée, notamment d'un plateau rotatif.

Plus particulièrement, bien que non exclusivement, la présente invention s'applique à un plateau rotatif (ou tournant) qui est destiné à des applications de positionnement de précision (inspection de plaques de semi-conducteur (« wafer »), métrologie, positionnement de composants, microrobotique,...) dans différents types de domaines : recherche, industrie, défense,...

Généralement, un tel dispositif d'entraînement en rotation d'une roue dentée comporte, de façon usuelle, notamment :
- une vis sans fin qui est destinée à venir en engrenage avec ladite roue dentée ; et
- un moteur, dont un axe d'entraînement est lié, par l'intermédiaire d'une courroie, à une première extrémité de ladite vis pour entraîner cette dernière en rotation. De plus, ce moteur est fixé par rapport à ladite vis.

Par ailleurs, en particulier pour faciliter la mise en place de la vis en engrènement avec la roue dentée, ce dispositif d'entraînement en rotation peut comporter de plus :
- un fourreau souple qui entoure la vis ; et
- des moyens de précontrainte qui sont réglables par un opérateur et qui permettent d'exercer une pression sur le fourreau au niveau d'une seconde extrémité de la vis opposée à ladite première extrémité, dans le but d'appliquer de façon appropriée la vis contre la roue dentée.

Toutefois, la pression exercée sur le fourreau souple par ces moyens de précontrainte est perturbée par la tension de la courroie s'exerçant à l'autre extrémité de sorte que les moyens de précontrainte ne peuvent pas mettre en oeuvre efficacement leur fonction. Cette perturbation peut entraîner des difficultés de montage et réduire la stabilité de positionnement de l'ensemble en fonctionnement.

Ce dispositif d'entraînement usuel n'est donc pas complètement satisfaisant.

Un dispositif selon le préambule de la revendication 1 est connu de DE 38 04 861 A1.

La présente invention a pour objet de remédier à ces inconvénients. Elle concerne un dispositif d'entraînement en rotation d'une roue dentée, permettant notamment aux moyens de précontrainte de remplir complètement et efficacement leur fonction.

A cet effet, selon l'invention, ledit dispositif du type comportant :
- une vis sans fin destinée à venir en engrenage avec ladite roue dentée ;
- un moteur qui est agencé parallèlement à ladite vis et dont un axe d'entraînement agencé à une première extrémité est lié, par l'intermédiaire d'une courroie, à une première extrémité de ladite vis pour entraîner cette dernière en rotation ;
- un fourreau souple qui entoure partiellement ladite vis de manière à former un ensemble dit vis/fourreau ; et
- des moyens de précontrainte réglables permettant d'exercer une pression sur l'ensemble vis/fourreau au niveau d'une seconde extrémité de la vis opposée à ladite première extrémité,
   est remarquable en ce que :
- ledit moteur est agencé dans une structure qui est montée pivotante par rapport à l'ensemble vis/fourreau ; et
- ledit dispositif comporte, de plus, des moyens de reprise d'effort qui sont agencés de manière à relier une seconde extrémité du moteur, opposée à ladite première extrémité, audit fourreau au niveau de ladite seconde extrémité de la vis.

Ainsi, grâce à l'invention, on découple la tension de la courroie et les moyens de précontrainte roue/vis. Le moteur n'est plus fixé par rapport à l'ensemble vis/fourreau, mais il est monté sur une structure qui est pivotante par rapport à cet ensemble. L'extrémité de cette structure (opposée à celle comprenant la courroie) est reliée au fourreau souple par des moyens de reprise d'effort. Ainsi, lorsque l'on tend la courroie (liant au niveau d'une première extrémité la structure (comprenant le moteur) à l'ensemble vis/fourreau), l'effort est repris à l'autre extrémité par les moyens de reprise d'effort (liant également la structure (comprenant le moteur) à l'ensemble vis/fourreau au niveau de cette autre extrémité) et ainsi ne perturbe plus le mécanisme d'application d'effort roue/vis.

Par conséquent, les moyens de précontrainte peuvent mettre en oeuvre efficacement leur fonction. Ceci permet de faciliter le montage et d'augmenter la stabilité de positionnement des différents éléments du dispositif en fonctionnement.

Dans le cadre de la présente invention, les moyens de reprise d'effort peuvent être réalisés de différentes manières. En particulier, lesdits moyens de reprise d'effort peuvent comprendre, de façon avantageuse :
- une lame souple ; ou
- une biellette.

L'ensemble vis/fourreau étant susceptible de pivoter autour d'un axe, avantageusement, l'axe du pivot de la structure pivotante est parallèle à l'axe du pivot de cet ensemble vis/fourreau, et ces deux axes de pivot sont agencés dans un plan qui est sensiblement orthogonal à l'axe (longitudinal) de la vis.

En outre, de façon avantageuse, un espace traversant est ménagé au niveau de la seconde extrémité du moteur pour permettre un accès facilité aux moyens de précontrainte.

La présente invention permet ainsi d'améliorer la chaîne cinématique de transmission de puissance d'une roue dentée, notamment d'un plateau rotatif.

La présente invention concerne également un système de génération d'un mouvement de rotation, comprenant une roue dentée engrenée avec une vis faisant partie de moyens d'entraînement. Selon l'invention, lesdits moyens d'entraînement comportent un dispositif d'entraînement du type précité.

La présente invention concerne en outre un plateau (ou platine) rotatif motorisé, qui est pourvu d'une roue dentée générant le mouvement rotatif du plateau et de moyens d'entraînement en rotation de cette roue dentée, qui comportent un dispositif d'entraînement tel que décrit ci-dessus.
Les figures du dessin annexé feront bien comprendre comment l'invention peut être réalisée. Sur ces figures, des références identiques désignent des éléments semblables.
La figure 1 est une vue schématique d'un dispositif d'entraînement usuel.
La figure 2 est une vue schématique d'un dispositif d'entraînement conforme à l'invention.
La figure 3 est une vue en coupe d'un mode de réalisation particulier d'un dispositif d'entraînement conforme à l'invention.

La présente invention concerne un dispositif 1 d'entraînement en rotation d'une roue dentée (ou pignon) 2, faisant notamment partie d'un plateau tournant (ou rotatif) motorisé (non représenté). Ce plateau peut en particulier être destiné à applications de positionnement de précision (inspection de plaques de semi-conducteur (« wafer »), métrologie, positionnement de composants, microrobotique,...) dans différents types de domaines : recherche, industrie, défense,...

La roue dentée 2 est entraînée en rotation autour d'un axe 4 parallèle à une direction Y (d'un repère R).

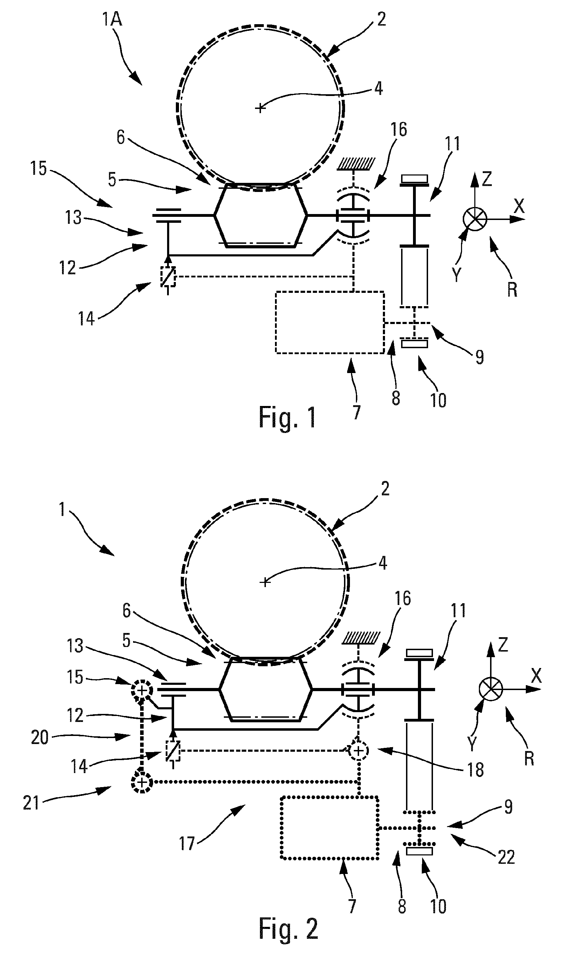

Un dispositif d'entraînement en rotation d'une roue dentée, conforme à un mode de réalisation usuel 1A, comporte, comme représenté schématiquement sur la figure 1, une vis sans fin 5 qui représente un cylindre comportant une cannelure hélicoïdale. Cette vis sans fin 5 est destinée à venir en engrenage avec la roue dentée 2 au niveau d'une zone 6, de sorte que, en position, l'axe longitudinal de la vis 5 présente une position tangentielle par rapport à la roue 2 suivant une direction X.

Associé avec cette roue dentée (ou pignon) 2, la vis sans fin 5 permet donc de changer l'axe de la rotation : alors que la vis 5 tourne autour de son axe de direction X, la roue dentée 2 tourne autour de l'axe 4 de direction Y perpendiculaire à X.

Le dispositif d'entraînement 1A comporte, de plus, un moteur électrique 7 de type usuel, qui est monté de façon fixe par rapport à la vis 5 et qui comprend à une extrémité 8 un axe d'entraînement 9 qui est parallèle à l'axe de la vis 5 (selon la direction X). De plus, l'axe d'entraînement 9 est lié, de façon usuelle, par l'intermédiaire d'une courroie 10, à une extrémité 11 de ladite vis 5 pour entraîner cette dernière en rotation, autour de la direction X, et ainsi pour entraîner en rotation ladite roue dentée 2 autour de son axe 4.

De plus, le dispositif d'entraînement 1 A comporte également :
- un fourreau souple 12 qui est par exemple réalisé en une pièce métallique déformable et qui entoure la vis 5, excepté au niveau de la zone de contact 6 entre la vis et la roue dentée 2 de manière à former un ensemble vis/fourreau 13 ; et
- des moyens de précontrainte 14, notamment des vis, qui sont réglables par un opérateur et qui permettent d'exercer une pression sur le fourreau 12 (et donc sur l'ensemble 13) au niveau d'une extrémité 15 de la vis opposée à ladite extrémité 11, dans le but d'appliquer la vis 5 contre la roue dentée 6 selon une direction Z (qui est orthogonale aux directions X et Y) de manière à lui conférer la position appropriée pour le fonctionnement. Pour ce faire, l'ensemble vis/fourreau 13 est monté de manière à pouvoir pivoter autour d'un axe de pivot 16 situé à l'extrémité 11 opposée à la zone d'action des moyens de précontrainte 14.

De préférence, le fourreau souple 12 est une pièce métallique déformable qui maintient rigidement le palier 15 suivant Y tout en lui permettant une translation suivant Z. Le palier 15 peut également être monté sur une platine de translation.

Dans cette réalisation usuelle de la figure 1, le moteur 7 du dispositif 1A présente donc une position fixe par rapport à l'ensemble fourreau/vis 13.

Les dernières caractéristiques permettent notamment de faciliter la mise en place et le positionnement exact de la vis 5 en engrènement avec la roue dentée 2.

Toutefois, dans ce mode de réalisation usuel 1A, la pression exercée sur le fourreau souple 12 par les moyens de précontrainte 14 est perturbée par la tension de la courroie 10 de sorte que les moyens de précontrainte 14 ne peuvent pas mettre en oeuvre efficacement leur fonction. Cette perturbation peut entraîner des difficultés de montage et réduire la stabilité de positionnement de l'ensemble en fonctionnement.

Le dispositif 1 conforme à l'invention et représenté schématiquement sur la figure 2 permet notamment de remédier aux inconvénients précités.

Ce dispositif 1 comporte les mêmes éléments 1 à 16 que ceux décrits précédemment du dispositif usuel 1A, à l'exception des caractéristiques précisées ci-dessous. Ces éléments similaires ne sont donc pas décrits une seconde fois dans la description ci-après.

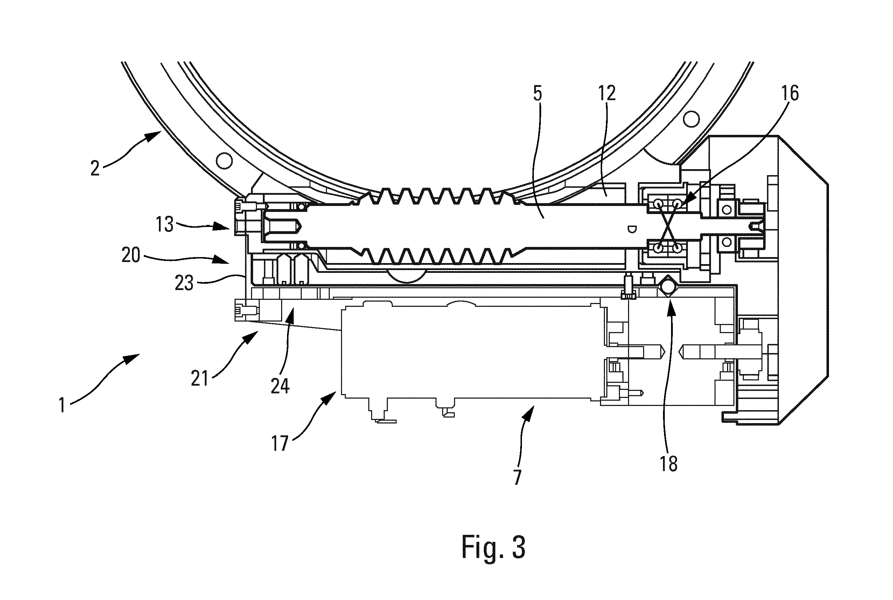

Selon l'invention, pour remédier aux inconvénients précités, le dispositif 1 conforme à l'invention et représenté sur les figures 2 et 3 présente les caractéristiques particulières suivantes (différentes de celles du dispositif usuel 1A).

Le moteur 7 fait partie d'une structure 17 qui est montée pivotante par rapport à l'ensemble vis/fourreau 13, en étant apte à pivoter autour d'un axe 18. L'axe de pivot 18 de ladite structure pivotante 17 est parallèle à l'axe de pivot 16 de l'ensemble vis/fourreau 13, ces axes 16, 18 étant agencés selon la direction Y. De plus, ces deux axes 16 et 18 définissent un plan qui est sensiblement orthogonal à l'axe (de direction X) de la vis 5.

En outre, ledit dispositif 1 comporte, de plus, des moyens de reprise d'effort 20 qui sont fixés :
- d'une part, à l'extrémité 21 de la structure 17 (comprenant le moteur 5), opposée à l'extrémité 22 pourvue de l'axe d'entraînement 9 ; et
- d'autre part, audit fourreau 12 au niveau de l'extrémité 15 de la vis 5, de manière à relier l'extrémité 21 du moteur 7 à l'extrémité 15 de l'ensemble fourreau/vis 13.

Grâce à ces caractéristiques conformes à l'invention, on découple sur le dispositif 1 la tension de la courroie 10 et les moyens de précontrainte roue/vis 14. Le moteur 7 n'est donc plus fixé par rapport à l'ensemble vis/fourreau 13 (comme dans le mode de réalisation usuel 1A), mais il est monté sur une structure 17 qui est susceptible de pivoter par rapport à cet ensemble 13. L'extrémité 21 de cette structure 17 est reliée au fourreau souple 12 par des moyens de reprise d'effort 20.

Ainsi, lorsque l'on tend la courroie 10 (liant la structure 17 à l'ensemble 13 à l'extrémité 11, 22), l'effort est repris à l'autre extrémité 15, 21 par les moyens de reprise d'effort 20 (liant également la structure 17 à l'ensemble 13 à cette autre extrémité 15, 21) et ne perturbe plus le mécanisme d'application d'effort roue/vis.

Par conséquent, les moyens de précontrainte 14 peuvent mettre en oeuvre efficacement leur fonction. Ceci permet de faciliter le montage de la vis 5 par rapport à la roue dentée 2 et d'augmenter la stabilité de positionnement de l'ensemble en fonctionnement.

Dans le cadre de la présente invention, les moyens de reprise d'effort 20 peuvent être réalisés de différentes manières. En particulier, lesdits moyens de reprise d'effort peuvent comprendre une lame souple 23, comme représenté sur la figure 3. Ces moyens de reprise d'effort 20 peuvent également comprendre une biellette ou tout autre moyen mécanique approprié.

Par ailleurs, un espace traversant 24 est ménagé au niveau de l'extrémité 21 de la structure 17 pour permettre à un opérateur d'accéder aux moyens de précontrainte 14, notamment par l'intermédiaire d'un tournevis, de sorte qu'il puisse régler la pression appropriée générée par ces moyens de précontrainte 14 dans le but d'appliquer la vis 5 contre la roue dentée.

La présente invention permet ainsi d'améliorer la chaîne cinématique de transmission de puissance d'une roue dentée 2, faisant notamment partie d'un plateau rotatif motorisé.

## Revendications

1. Dispositif d'entraînement en rotation d'une roue dentée (2), ledit dispositif (1) comportant :
- une vis sans fin (5) destinée à venir en engrenage avec ladite roue dentée (2) ;
- un moteur (7) qui est agencé parallèlement à ladite vis (5) et dont un axe d'entraînement (9) agencé à une première extrémité (22) est lié, par l'intermédiaire d'une courroie (10), à une première extrémité (11) de ladite vis (5) pour entraîner cette dernière en rotation ;
- un fourreau souple (12) qui entoure partiellement ladite vis (5) de manière à former un ensemble dit vis/fourreau (13) ; et
- des moyens de précontrainte (14) réglables permettant d'exercer une pression sur l'ensemble vis/fourreau (13) au niveau d'une seconde extrémité (15) de la vis (5) opposée à ladite première extrémité (11), **caractérisé en ce que** :
- ledit moteur (7) est agencé dans une structure (17) qui est montée pivotante par rapport à l'ensemble vis/fourreau (13) ; et
- ledit dispositif (1) comporte, de plus, des moyens de reprise d'effort (20) qui sont agencés de manière à relier une seconde extrémité (21) du moteur (7), opposée à ladite première extrémité (22), audit fourreau (12) au niveau de ladite seconde extrémité (15) de la vis (5).

2. Dispositif selon la revendication 1,
**caractérisé en ce que** lesdits moyens de reprise d'effort (20) comprennent une lame souple (23).

3. Dispositif selon la revendication 1,
**caractérisé en ce que** lesdits moyens de reprise d'effort (20) comprennent une biellette.

4. Dispositif selon l'une des revendications 1 à 3,
**caractérisé en ce que**, l'ensemble vis/fourreau (13) étant susceptible de pivoter autour d'un axe (16), l'axe (18) du pivot de ladite structure pivotante (17) est parallèle à l'axe (16) du pivot de cet ensemble vis/fourreau (13), et **en ce que** ces axes de pivot (16, 18) sont agencés dans un plan qui est sensiblement orthogonal à l'axe (X) de la vis (5).

5. Dispositif selon l'une quelconque des revendications précédentes,
**caractérisé en ce qu'**un espace traversant (24) est ménagé au niveau de la seconde extrémité (21) du moteur (7) pour permettre un accès aux moyens de précontrainte (14).

6. Système de génération d'un mouvement de rotation comprenant une roue dentée (2) engrenée avec une vis sans fin (5) faisant partie de moyens d'entraînement,
**caractérisé en ce que** lesdits moyens d'entraînement comportent un dispositif (1) tel que celui spécifié sous l'une quelconque des revendications 1 à 5.

7. Plateau rotatif motorisé, pourvu d'une roue dentée (2) générant un mouvement rotatif du plateau et de moyens d'entraînement en rotation de cette roue dentée,
**caractérisé en ce que** lesdits moyens d'entraînement comportent un dispositif (1) tel que celui spécifié sous l'une quelconque des revendications 1 à 5.

## Patentansprüche

1. Drehantriebsvorrichtung eines Zahnrads (2), wobei die Vorrichtung (1) aufweist:
- eine Schnecke (5), die zum Eingriff mit dem Zahnrad (2) bestimmt ist,
- einen Motor (7), der parallel zur Schnecke (5) ausgebildet ist und von dem eine an einem ersten Ende (22) ausgebildete Antriebswelle (9) mittels eines Riemens (10) mit einem ersten Ende (11) der Schnecke (5) verbunden ist, um diese drehend anzutreiben,
- eine elastische Hülse (12), welche die Schnecke (5) zum Teil derart umschließt, dass eine Einheit Schnecke/Hülse (13) gebildet wird, und
- einstellbare Vorspannungsmittel (14), die erlauben, einen Druck auf die Einheit Schnecke/Hülse (13) im Bereich eines zweiten Endes (15) der Schnecke (5), das dem ersten Ende (11) gegenüberliegt, auszuüben, **dadurch gekennzeichnet, dass**:
- der Motor (7) in einer Struktur (17) ausgebildet ist, die im Verhältnis zur Einheit Schnecke/Hülse (13) schwenkbar montiert ist, und
- die Vorrichtung (1) zusätzlich Kraftübernahmemittel (20) aufweist, die derart ausgebildet sind, dass ein zweites Ende (21) des Motors (7), das dem ersten Ende (22) gegenüberliegt, mit der Hülse (12) im Bereich des zweiten Endes (15) der Schnecke (5) verbunden ist.

2. Vorrichtung nach Anspruch 1,
**dadurch gekennzeichnet, dass** die Kraftübernahmemittel (20) eine elastische Zunge (23) umfassen.

3. Vorrichtung nach Anspruch 1,
**dadurch gekennzeichnet, dass** die Kraftübernahmemittel (20) einen Schwingarm umfassen.

4. Vorrichtung nach einem der Ansprüche 1 bis 3,
**dadurch gekennzeichnet, dass** die Einheit Schnecke/Hülse (13) imstande ist, um eine Welle (16) zu schwenken, wobei die Drehzapfenwelle (18) der schwenkenden Struktur (17) parallel zur Drehzapfenwelle (16) dieser Einheit Schnecke/Hülse (13) ist und dass diese Drehzapfenwellen (16, 18) in einer Ebene ausgebildet sind, die zur Achse (X) der Schnecke (5) etwa orthogonal ist.

5. Vorrichtung nach einem der vorangehenden Ansprüche,
**dadurch gekennzeichnet, dass** im Bereich des zweiten Endes (21) des Motors (7) ein durchgehender Raum (24) ausgebildet ist, um einen Zugriff auf die Vorspannungsmittel (14) zu erlauben.

6. System zur Erzeugung einer Drehbewegung, das ein Zahnrad (2) umfasst, das mit einer Schnecke (5) eingreift, die Teil der Antriebsmittel ist,
**dadurch gekennzeichnet, dass** die Antriebsmittel eine Vorrichtung (1) nach einem der Ansprüche 1 bis 5 aufweisen.

7. Motorgetriebener Drehteller, der mit einem Zahnrad (2) ausgestattet ist, das eine Drehbewegung des Drehtellers erzeugt, und mit Drehantriebsmitteln dieses Zahnrads,
**dadurch gekennzeichnet, dass** die Antriebsmittel eine Vorrichtung (1) nach einem der Ansprüche 1 bis 5 aufweisen.

## Claims

1. Device for driving in rotation a toothed wheel (2), said device (1) having:
- a worm (5) intended to mesh with said toothed wheel (2);
- a motor (7) that is arranged parallel to said worm (5) and of which a drive shaft (9) arranged at a first extremity (22) is connected, via a belt (10), to a first extremity (11) of said worm (5) in order to drive the worm in rotation;
- a flexible sleeve (12) that partially surrounds said worm (5) in such a way as to form an assembly described as a worm/sleeve assembly (13); and
- adjustable pre-stressing means (14) enabling pressure to be exerted on the worm/sleeve assembly (13) at a second extremity (15) of the worm (5) opposite said first extremity (11),
**characterised in that**:
- said motor (7) is arranged in a structure (17) that is fitted pivotably relative to the worm/sleeve assembly (13); and
- said device (1) also has a force transfer means (20) that is arranged so as to connect a second extremity (21) of the motor (7), opposite said first extremity (22), to said sleeve (12) at said second extremity (15) of the worm (5).

2. Device according to claim 1,
**characterised in that** said force transfer means (20) comprises a flexible contact (23).

3. Device according to claim 1,
**characterised in that** said force transfer means (20) comprises a connecting rod.

4. Device according to claims 1 to 3,
**characterised in that** as the worm/sleeve assembly (13) is able to pivot around an axis (16), the axis (18) of pivot of said pivoting structure (17) is parallel to the axis (16) of pivot of this worm/sleeve assembly (13), and **in that** these axes of pivot (16, 18) are arranged in a plane that is approximately orthogonal to the axis (X) of the worm (5).

5. Device according to any of the preceding claims,
**characterised in that** a traversing space (24) is arranged at the second extremity (21) of the motor (7) to allow access to the pre-stressing means (14).

6. System for producing a rotary movement comprising a toothed wheel (2) meshed with a worm (5) forming part of drive means,
**characterised in that** said drive means includes a device (1) like that specified in any of claims 1 to 5.

7. Motorised turntable, provided with a toothed wheel (2) producing a rotary movement of the turntable and with means for driving this toothed wheel in rotation, **characterised in that** said drive means has a device (1) like that specified in any of claims 1 to 5.
